# EUROPEAN PATENT SPECIFICATION

(11) **EP 2 054 896 B1**
(45) Date of publication and mention of the grant of the patent: **13.06.2012**
(21) Application number: 07813508.4
(22) Date of filing: 29.07.2007
(51) Int. Cl.: H01B 1/24

(54) **VOLTAGE SWITCHABLE DIELECTRIC MATERIAL HAVING CONDUCTIVE OR SEMI-CONDUCTIVE ORGANIC MATERIAL**
DIELEKTRISCHES MATERIAL MIT UMSCHALTBARER SPANNUNG UND EINEM LEITENDEN ODER HALBLEITENDEN MATERIAL
MATÉRIAU DIÉLECTRIQUE COMMUTABLE PAR LA TENSION COMPORTANT UN MATÉRIAU ORGANIQUE CONDUCTEUR OU SEMI-CONDUCTEUR

(30) Priority: 29.07.2006 US 820786 P; 24.09.2006 US 826746 P; 21.11.2006 US 562289; 21.11.2006 US 562222; 11.07.2007 US 949179 P
(43) Date of publication of application: 06.05.2009
(60) Divisional application: 11188515.8
(73) Proprietor: Shocking Technologies, Inc., San Jose, CA 95131 (US)
(72) Inventor: KOSOWSKY, Lex, San Jose, California 95138 (US); FLEMING, Robert, San Jose, California 95119-1926 (US)
(74) Representative: Potter, Julian Mark
(86) International application number: PCT/US2007/074676
(87) International publication number: WO 2008/016858

(56) References cited:
- EP-A- 1 542 240
- WO-A-99/24992
- US-A1- 2003 010 960
- US-A1- 2004 211 942

## Description

### RELATED APPLICATIONS

This applications claims priority to provisional U.S. Patent Application No. 60/820,786, filed July 29, 2006, entitled "Voltage Switchable Dielectric Material With Reduced Metal Loading,"

This applications also claims priority to provisional U.S. Patent Application No. 60/826,746, filed September 24, 2006, entitled "Voltage Switchable Device and Dielectric Material With High Current Carrying Capacity and a Process for Electroplating the Same,"

This application also claims benefit of priority to provisional U.S. Patent Application No. 60/949,179, filed July 11, 2007, entitled "Binders for Voltage Switchable Dielectric Materials,".

This application is a continuation-in-part of U.S. Patent Application No. 11/562,289, filed November 21, 2006, entitled "Light Emitting Device Using Voltage Switchable Dielectric Material"; which claims benefit of Provisional U.S. Patent Application No. 60/739,725, filed November 22, 2005, entitled "RFID Tag Using Voltage Switchable Dielectric Material"; and which claims benefit of 60/740,961, filed November 30, 2005, entitled "Light Emitting Devices with ESD Characteristics".

This application is a continuation-in-part of U.S. Patent Application No. 11/562,222, filed November 21, 2006, entitled "Wireless Communication Device Using Voltage Switchable Dielectric Material"; which claims benefit of Provisional U.S. Patent Application No. 60/739,725, filed November 22, 2005, entitled "RFID Tag Using Voltage Switchable Dielectric Material"; and which claims benefit of 60/740,961, filed November 30, 2005, entitled "Light Emitting Devices with ESD Characteristics"

This application is a continuation-in-part of U.S. Patent No. 6,797,145, issued on September 28, 2004, entitled "Current Carrying Structure Using Voltage Switchable Dielectric Material"; which is a continuation of U.S. application Ser. No. 09/437,882, filed Nov. 10,1999, now abandoned, and claims benefit of U.S. Provisional Application No. 60/151,188, filed on Aug. 27,1999.

### TECHNICAL FIELD

The disclosed embodiments relate generally to the field of electronic devices, and more particularly, to devices that incorporate voltage switchable dielectric (VSD) materials.

### BACKGROUND

Voltage switchable dielectric (VSD) material has an increasing number of applications. These include its use on, for example, printed circuit boards and device packages, for purpose of handling transient voltages and electrostatic discharge events (FSD).

Various kinds of conventional VSD material exist. Examples of voltage switchable dielectric materials are provided in references such as U.S. Pat. No. 4,977,357, U.S. Pat. No. 5,068,634, U.S. Pat. No. 5,099,380, U.S. Pat. No. 5,142,263, U.S. Pat. No. 5,189,387, U.S. Pat. No. 5,248,517, U.S. Pat. No. 5,807,509, WO 96/02924, and WO 97/26665. VSD material can be "SURGX" material manufactured by the SURGX CORPORATION (which is owned by Littlefuse, Inc.). WO99/24922 discloses a composition and devices utilizing these compositions for providing protection against electrical overstress including a matrix formed of a mixture of an insulating binder, conductive particles having an average particle size of less than 10 microns, and semiconductive particles having an average particle size of less than 10 microns. The compositions exhibit improved clamping voltages in a range of about 30 volts to greater than 2,000 volts,

While VSD material has many uses and applications, conventional compositions of the material have had many shortcomings. Typical conventional VSD materials are brittle, prone to scratching or other surface damage, lack adhesive strength, and have a high degree of thermal expansion.

### BRIEF DESCRIPTION OF THE DRAWINGS

FIG. 1 is a block diagram illustrating components for use in a process of formulating VSD material, according to an embodiment of the invention.

FIG. 2 illustrates a process for formulating a composition of VSD material having organic material, under an embodiment of the invention.

FIG. 3A is a cross-sectional illustration of VSD material, where the VSD material is formulated in accordance with one or more embodiments of the invention.

FIG. 3B illustrates a graph of basic electrical properties of clamp and trigger voltage for VSD material, in accordance with embodiments such as described with FIG. 3A and elsewhere.

FIG. 3C-FIG. 3E illustrate voltage by current performance graphs of different examples of VSD material, responding to the occurrence of voltage events, under one or more embodiments of the invention.

FIG. 4 illustrates another process by which VSD material may include organic material that coats conductors or semi-conductors, under an embodiment of the invention.

FIG. 5A and FIG. 5B illustrate how application of organic material to coat the surface of the metal/inorganic conductor or semiconductors can reduce loading of such particles, under an embodiment of the invention.

FIG. 5C illustrates a relatively disorganized distribution of organic fillers, reflecting effects of organic fillers distributed at the nanoscale within a binder of VSD material, according to an embodiment of the invention.

FIG. 6A and FIG. 6B each illustrate different configurations for a substrate device that is configured with VSD material having organic components ("organic VSD"), under an embodiment of the invention.

FIG. 7 illustrates a process for electroplating, using organic VSD material in accordance with any of the embodiments described with FIG. 1-5C

FIG. 8 is a simplified diagram of an electronic device on which VSD material in accordance with embodiments described herein may be provided.

### DETAILED DESCRIPTION

Embodiments described herein provide for devices that incorporate a composition of VSD material that includes organic conductive or semi-conductive material. As described herein, the use of organic conductive or semi-conductive material enables the formulation of VSD material that has several improved or desired characteristics that are not provided by more conventional VSD formulations.

Accordingly, one or more embodiments provide for devices that incorporate, integrate or otherwise provide a formulation of VSD material that has benefits that includes, for example, one or more of the following: (i) has improved mechanical properties, including having inherent properties of high compression strength, scratch resistance and non-brittleneas; (ii) has improved thermal properties: (iii) has high adhesive strength; (iv) has good ability to adhere to copper; or (v) lower degree of thermal expansion, as compared to more conventional VSD materials.

With regard to VSD formulations on such devices, one or more embodiments provide for a composition that includes (i) organic material that is conductive or semi-conductive, and (ii) conductor and/or semiconductor particles other than the organic material. The conductive/semi-conductive organic material may be solvent soluble, or dispersed at nanoscale within the composition of VSD material. The organic material and the conductor and/or semiconductor particles are combined to provide the composition with electrical characteristics of VSD material, including that of being (i) dielectric in absence of a voltage that exceeds a characteristic voltage level, and (ii) conductive with application of the voltage exceeding the characteristic voltage level.

According to embodiments described herein, the organic conductive/semi-conductive material may be uniformly mixed into a binder of the VSD mixture. In one embodiment, the mixture is dispersed at nanoscale, meaning the particles that comprise the organic conductive/semi-conductive material are nano-scale in at least one dimension (e.g. cross-section) and a substantial number of the particles that comprise the overall dispersed quantity in the volume are individually separated (so as to not be coagulated or compacted together).

Still further, one or more embodiments include VSD material having carbon nanotubes. In one embodiment, a binder of the VSD material includes carbon nanotubes that are substantially uniformly mixed, so as to be distributed at nanoscale.

In another embodiment, a method is provided for creating a voltage switchable dielectric material. A mixture is created containing (i) a a binder that is dielectric, (ii) metallic and or inorganic conductor or semi-conductor particles, and (iii) conductive or semi-conductive organic material. In creating the mixture, a quantity of each of the binder, the metallic and/or inorganic conductor or semi-conductor particles, and the organic material, is used. The mixture, when cured, is (i) dielectric in absence of a voltage that exceeds a characteristic voltage, and (ii) conductive in presence of the voltage that exceeds the characteristic voltage. The mixture may then be cured to form the VSD material.

With an embodiment such as described, the characteristic voltage may range in values that exceed the operational voltage levels of the circuit or device several times over. Such voltage levels may be of the order of transient conditions, such as produced by electrostatic discharge, although embodiments may include use of planned electrical events. Furthermore, one or more embodiments provide that in the absence of the voltage exceeding the characteristic voltage, the material behaves similar to the binder.

Still further, an embodiment provides for VSD material formed from the stated process or method.

Still further, an electronic device may be provided with VSD material in accordance with any of the embodiments described herein. Such electrical devices may include substrate devices, such as printed circuit boards, semiconductor packages, discrete devices, Light Emitting Diodes (LEDs), and radio-frequency (RF) components.

In an embodiment, the organic material is a fullerene. According to one embodiment, the organic material is a single or multi-walled carbon nanotube.

As used herein, "voltage switchable material" or "VSD material" is any composition, or combination of compositions, that has a characteristic of being dielectric or non-conductive, unless a voltage is applied to the material that exceeds a characteristic voltage level of the material, in which case the material becomes conductive. Thus, VSD material is a dielectric unless voltage exceeding the characteristic level (e.g. such as provided by ESD events) is applied to the material, in which case the VSD material is conductive. VSD material can further be characterized as any material that can be characterized as a nonlinear resistance material.

VSD material may also be characterized as being non-layered and uniform in its composition, while exhibiting electrical characteristics as stated.

Still further, an embodiment provides that VSD material may be characterized as material comprising a binder mixed in part with conductor or semi-conductor particles. In the absence of voltage exceeding a characteristic voltage level, the material as a whole adapts the dielectric characteristic of the binder. With application of voltage exceeding the characteristic level, the material as a whole adapts conductive characteristics.

Generally, the characteristic voltage of VSD material is measured at volts/length per 0.127mm (per 5 mil). One or more embodiments provide that VSD material has a characteristic voltage level that exceeds that of an operating circuit.

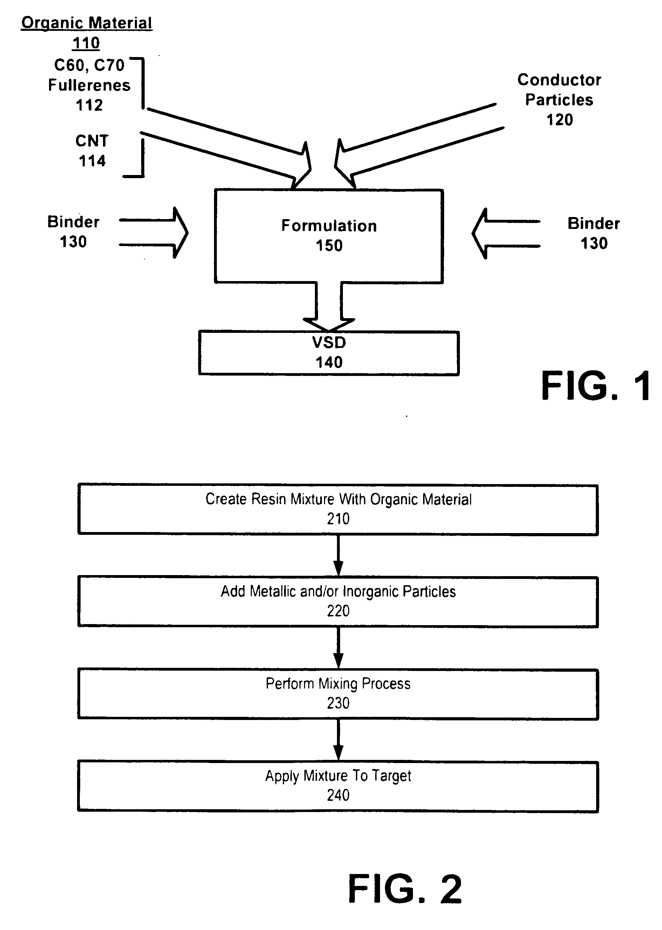

FIG. 1 is a block diagram illustrating components for use in a process of formulating VSD material, according to an embodiment of the invention. According to an embodiment, conductive or semi-conductive organic material ("organic material") 110 is combined with conductor(and/or) semi-conductor particles 120 to form VSD material 140. As an optional addition, insulator particles may also be combined with the conductor/semiconductor particles 120. In one embodiment, the organic material 110 is combined with conductor/semi-conductor particles 120 that are non-organic. Binder materials 130 may be combined with the organic material 110 and the conductive particles to form the VSD material 140. A VSD formulation process 150 may be used to combine the various constituents of the VSD material 140. Formulation processes for combining VSD material with organic material are described below, with, for example, an embodiment of FIG. 2.

In one embodiment, the binder 130 is a binder that retains the conductive/semi-conductive organic material 110 and the conductor/semi-conductor particles 120. In one embodiment, the organic material 110 is dispersed as nanoscale particles. As dispersed nanoscale particles, the organic material 110 includes particles that are nanoscaled and individually separated from one another, rather than attached or agglomerated. The formulation process 150 may uniformly disperse the particles within the binder of the binder 130.

In an embodiment of FIG. 1, the organic material is dispersed fullerenes. Examples of fullerenes that are suitable for use with one or more embodiments described herein include C60 or C70 fullerenes 112, sometimes referred to as Buckyballs. Such fullerenes may be functionalized, to provide a covalently bonded chemical group or moiety. In another embodiment, carbon nanotubes 114 may be used, which are cylindrical shaped fullerenes. The carbon nanotubes 114 may be of either a single or multi-wall variety. Still further, one or more embodiments contemplate a quantity formed from a combination of different types of fullerenes, including carbon nanotubes.

According to one or more embodiments, other ingredients or components for use in the formation process 150 include solvents and catalysts. Solvents may be added to the binder of the binder 130 to separate particles. A mixing process may be used to uniformly space separated particles. In one embodiment, the result of the mixing process is that the composition is uniformly mixed to disperse the particles at the nanoscale. Thus, particles such as carbon nanotubes may be separated out individually and distributed relatively evenly in the material. In order to achieve nanoscale dispersion, one or more embodiments provide for use of sonic agitators and sophisticated mixing equipment (e.g. rotor-stator mixers, ball mills, mini-mills and other high shear mixing technologies), over a duration that last several hours or longer. Once mixed, the resulting mixture may be cured or dried.

As an alternative or addition to use of nanoscale distributed particles, one or more embodiments provide for the conductive/semi-conductive organic material 110 to be solvent soluble. In one embodiment, the conductive/semi-conductive organic material 110 is added to the binder and mixed with solvent. During the drying process, the solvent is removed, leaving the conductive/semi-conductive organic material 110 remaining uniformly mixed within the cured material. An example of solvent soluble material is poly-3-hexylthiophene. The solvent may correspond to toluene. As a result of the curing step in the formulation process 150, the poly-3-hexylthiophene remains in the VSD material 140.

Thus, as an alternative or addition to fullerenes, numerous other types of conductive/semi-conductive organic material are contemplated for use with VSD material, according to embodiments of the invention. These include: poly-3-hexylthiophene (as discussed above), Polythiophene, a Polyactetylene, a Poly(3,4-ethylenedioxythiophene) poly(styrenesulfonate), a Pentacene, (8-hydroxyquinolinolato) aluminum (III), N,N'-Di-[(naphthalenyl)-N,N'diphenyl]-1,1'-biphenyl-4,4'-diamine [NPD, a conductive carbon graphite or carbon fiber, diamond powder, and a conductive polymer.

Thus, as an alternative or variation to an embodiment described, the organic material may correspond to a compound that is solvent soluble.

According to another embodiment, other kinds of conductive or semi-conductive organic material may be used. These include conductive/semi-conductive monomers, oligomers, and polymers. By classification, the conductive or semi-conductive organic material may correspond to variations of monomers, oligomer, and polymers of thiophenes (such as poly-3-hexylthiophene or Polythiophene), anilines, phenylenes, vinylenes, flourenes, naphthalene, pyrrole, acetylene, carbazole, pyrrolidone, cyano materials, anthracene, pentacene, rubrene, perylene, or oxadizoles. Still further, the conductive or semi-conductive organic material may correspond to Poly(3,4ethylenedioxyhiophene)/poly(styrenesulfonate), (8-hydroxyquinolinolato) aluminum (111), N,N'-Bis(3-methylphenyl-N,N'-diphenylbenzidine [TPD], N,N'-Di-[(naphthalenyl)-N,N'diphenyl]-1.1'-biphenyl-4.4'-diamine [NPD].

The conductor/semi-conductor particles 120 may correspond to conductors or semi-conductors. One or more embodiments provide for use of inorganic semi-conductor particles that include silicon, silicon carbide, or titanium dioxide, boron nitride, aluminum nitride, nickel oxide, zinc oxide, zinc sulfide, bismuth oxide, cerium oxide, iron oxide, metal or/and complexes selected from a group consisting of oxides, metal nitrides, metal carbides, metal borides, metal sulfides, or a combination thereof.

The binder 130 may also be of various types. The binder 130 may be provided in the form of a binder that retains the conductor/semiconductor organic material 1 10 and the conductor/semiconductor particles 120. According to different embodiments, the binder 130 is formed from a material selected from a group consisting of silicone polymers, epoxy, polyimide, polyethylene, polypropylene, polyphenylene oxide, polysulphone, solgel materials, and ceramers. According to one or more embodiments, the binder 130 is a binder that suspends and/or retains the organic material 1 10 and the conductor/semi-conductor particles 120. as well as other particles or compounds that comprise the VSD material 140. Additionally, the binder 130 may include solvents and other elements not specifically described herein.

VSD FORMULATION WITH ORGANIC MATERIAL

Broadly, embodiments provide for use of VSD material that includes, by percentage of volume, 5-99% binder, 0-70% conductor, 0-90% semiconductor, and 0.01-95% organic conductive or semi-conductive material. One or more embodiments provide for use of VSD material that includes, by percentage of volume, 20 to 80% binder, 10-50% conductor, 0% to 70% semiconductor, and organic material that is conductive or semi-conductive and having a volume of the composition in a range of 0.01-40%. Still further, one embodiment provides for use of VSD material that includes, by percentage of volume, 30 to 70% binder, 15-45% conductor, 0% to 50% semiconductor, and organic material that is conductive or semi-conductive and having a volume of the composition in a range of 0.01-40%. Examples of binder materials include silicone polymers, epoxy, polyimide, phenolic resins, polyethylene, polypropylene, polyphenylene oxide, polysulphone, solgel mateterials, ceramers and inorganic polymers. Examples of conductors include metals such as copper, aluminum, titanium, nickel, stainless steel, chrome and other alloys. Examples of semiconductors include both organic and inorganic semiconductors. Some inorganic semiconductors include silicon, silicon carbide, boron nitride, aluminum nitride, nickel oxide, zinc oxide, zinc sulfide, bismuth oxide, and iron oxide. Examples of organic semiconductors include poly-3-hexylthiophene, pentacene, perylene (or derivatives thereof), carbon nanotubes, C60 fullerenes and diamond. The specific formulation and composition may be selected for mechanical and electrical properties that best suit the particular application of the VSD material.

FIG. 2 illustrates a process for formulating a composition of VSD material having organic material, according to an embodiment of the invention. Initially, in a step 210, a resin mixture is created having conductive and semi-conductive organic particles (or alternatively solvent solubles). The resin mixture may serve as the binder of the VSD material when formulation is complete. In one embodiment, the organic material may correspond to carbon nanotubes. The amount of organic material added to the mixture may vary, depending on the desired by weight or by percentage by volume of the organic material in the formulated VSD material. In one embodiment in which carbon nanotubes are used, the quantity of carbon nanotubes added to the resin results in carbon nanotubes having a percentage by weight of less than 10% of the overall composition, and more specifically between 0.01% and 10% of the formulated VSD material. More generally, the amount of organic material added to the resin may be based on using organic material that has a percentage by weight of the formulated VSD material that is less than the percolation threshold of the mixture.

In step 220, metallic and/or inorganic conductors/semiconductors are added to the mixture. As described with an embodiment of FIG. 1, numerous types of conductors or semi-conductors may be used. More than one kind of organic/semiconductor particle may be added. In one embodiment, Titanium dioxide (TiO₂) is used as the (or one of the) primary types of conductive/semiconductive particles, along with additional conductor particles. Additional curative and catalyst constituents and insulative particles may also be added to the mixture.

In step 230, a mixing process may be performed over a designated duration. In one embodiment, the mixing process is performed with mixing equipment, including sonic agitators, for a duration that that extends for several minutes or hours.

In step 240, the mixture is applied to its desired target. For example, the mixture may be applied to across a 0.127mm (5 mil) gap between two given electrodes of a particular device. At the target location, the mixture is cured into VSD material.

As described with an embodiment of FIG. 1, the resulting VSD material has numerous improved mechanical properties over more conventional VSD material. For example, among other improvements that may result, the VSD material formulated in accordance with an embodiment such as described may be less brittle, have better compression strength, adhere better to metals (particularly copper), and/or have better aesthetic properties.

EXAMPLE FORMULATION AND COMPOSITION

A compound in accordance with embodiments described herein may be formulated as follows: Organic material, such as carbon nanotubes (CNT) are added to a suitable resin mixture. In one embodiment, the resin mixture includes Epon 828 and a silane coupling agent. NMP (N-methyl-2pyrrolidone) may be added to the resin mixture. Subsequently, conductor or semiconductor particles may be added to the mixture. In one embodiment, titanium dioxide is mixed into the resin, along with titanium nitride, titanium diboride, a curative compound or agent, and a catalyst agent. The mixture may be uniformly mixed for a mixing duration that lasts hours (e.g. 8 hours) using, for example, a rotor-stator mixer with sonication. NMP may be added as necessary for the mixing duration. The resulting mixture may be applied as a coating using #50 wire wound rod or screen print on a desired target. In one embodiment, the coating may be applied across a 0.127mm (5 mil) gap between 2 electrodes. Subsequently, a cure process may take place that may be varied. One suitable curing process includes curing for ten minutes at 75 C, ten minutes at 125 C, 45 minutes at 175 C, and 30 minutes at 187 C.

Specific formulations may vary based on design criteria and application. One example of a formulation in which carbon nanotubes are used for organic material 110 includes:

| Epoxy Type | | Weight (g) |
|---|---|---|
| | | |
| CheapTubes | | 5.4 |
| | | |
| | Epon 828 | 100 |
| | Gelest Aminopropyltriethoxysilane | 4 |
| Total Epoxy | | 104 |
| Nanophase Bismuth Oxide | | 98 |
| | | |
| HC Starch TiN | | 164 |
| | Degussa Dyhard T03 | 4.575 |
| | NMP | 25.925 |
| Curative Soln. | | 30.5 |
| 1 -methylimidazole | | 0.6 |
| | HC Stark TiB2 | 149 |
| | Millenium Chemical Doped TiO2 | 190 |
| | | |
| | NMP | 250 |
| Total Solution | | 986.1 |
| Total Solids | | 715.575 |
| | Epoxy : Amin Equiv Ratio % Solids | 72.6% |

| | | |
|---|---|---|
| *Curative Solution is a 15% by weight solution of Dyhard T03 dissolved in NMP. | | |

Carbon nanotubes have the benefit of being a high aspect ratio organic filler. The lengths or aspect ratios may be varied to achieve a desired property, such as switching voltage for the material.

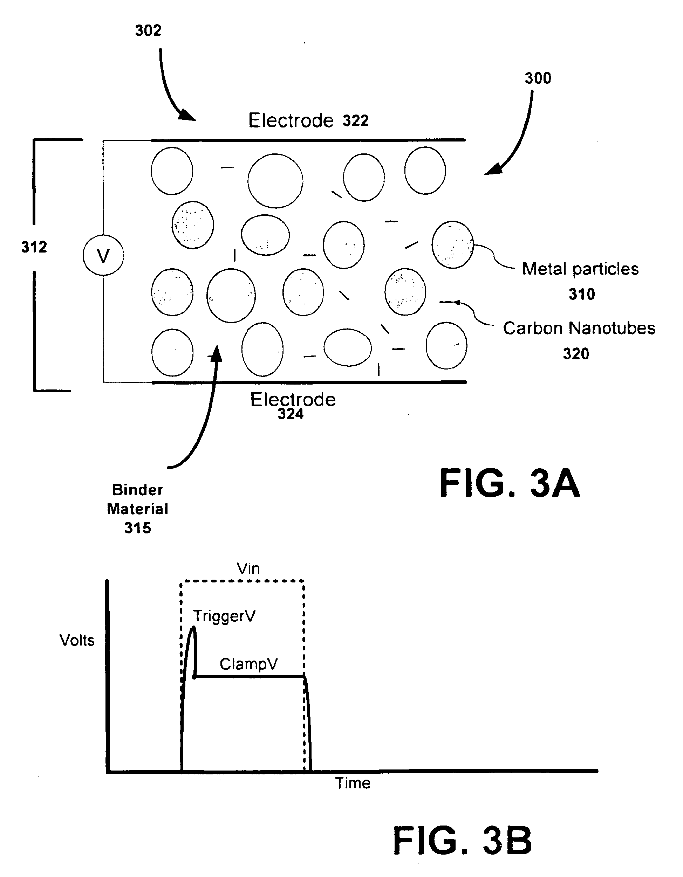

FIG. 3A is a cross-sectional illustration of VSD material provided on a device 302, where the VSD material is formulated in accordance with one or more embodiments of the invention. In an embodiment, a thickness or laver or VSD material 300 includes basic constituents of metal particles 310, binder material 3 15. and carbon nanotubes 320. As an alternative or addition to use of carbon nanotubes 320, other organic material may be used, such as C60 or C70 fullerenes (which may or may not be functionalized). Additionally, the use of organic conductors and semi-conductors provide ability to use electron donor or electro acceptor molecules.

Embodiments recognize, however, that carbon nanotubes have considerable length to width ratio. This dimensional property enables carbon nanotubes to enhance the ability of the binder to pass electrons from conductive particle to conductive particle in the occurrence of a transient voltage that exceeds the characteristic voltage. In this way, carbon nanotubes can reduce the amount of metal loading present in the VSD material. By reducing the metal loading, physical characteristics of the layer may be improved. For example, as mentioned with one or more other embodiments, the reduction of metal loading reduces the brittleness of the VSD material 300.

Furthermore, while an embodiment of FIG. 3A illustrates organic material in particulate form with the layer of VSD material, one or more embodiments contemplate use of an organic solvent soluble within the binder 315.

As described with an embodiment of FIG. 2, the VSD material 300 may be formed on device 302 by being deposited as a mixture on a target location of the device 302. The target location may correspond to a span 312 between a first and second electrode 322, 324. According to one or more embodiments, the span 312 is about (i.e. within 60%) 0.0762mm (3.0 mil), 0.127mm (5.0 mil), or 0.1905mm (7.5 mil) for applications such as printed circuit boards. However, the exact distance of the span 312 may vary based on design specification (e.g. gap distance may range between 0.0508mm (2 mils) and 0.254mm (10 mil) for printed circuit board applications). Moreover, some applications, such as semiconductor packaging, may use, for example, much smaller gap distances. Application of the VSD material in the gap enables handling of current that result from transient voltages that exceed the characteristic voltage of the VSD material.

Device 302 may correspond to anyone of many kinds of electrical devices. In an embodiment, device 302 be implemented as part of a printed circuit board. For example, the VSD material 300 may be provided as a thickness that is on the surface of the board, or within the board's thickness. Device 302 may further be provided as part of a semi-conductor package, or discrete device.

Alternatively, device 302 may be used with, for example, a light-emitting diode, a radio-frequency tag or device, or a semiconductor package.

As described with other embodiments, VSD material, when applied to a target location of a device, may be characterized by electrical properties such as characteristic (or trigger) voltage, clamp voltage, leakage current and current carrying capacity. Embodiments described herein provide for use of conductive or semi-conductive organic material in a mixture that enables adjustment of electrical properties such as described, while maintaining several desired mechanical properties described elsewhere in this application.

FIG. 3B illustrates a graph of basic electrical properties of clamp and trigger voltage for VSD material, in accordance with embodiments such as described with FIG. 3A and elsewhere in this application. Generally, the characteristic or trigger voltage is the voltage level (which may vary per unit length) by which the VSD material turns on or becomes conductive. The clamp voltage is typically less than or equal to the trigger voltage and is the voltage required to maintain the VSD material in the on-state. In some cases when the VSD material is provided between two or more electrodes, the trigger and clamp voltages may be measured as output across the VSD material itself. Thus, the on-state of the VSD material may be maintained by maintaining the input voltage level at above the clamp voltage, for a duration that is less than the break down threshold energy or time. In application, the trigger and/or clamp voltages may be varied as a result of an input signal that is spiked, pulsed, shaped or even modulated over several pulses.

Embodiments further recognize that another electrical property of interest includes off-state resistance, determined by measuring current through operational voltages of the device. The resistivity of the off-state may correspond to the leakage current. A change in off-state resistivity as compared to before and after when the VSD material is turned on and off signals degradation of the performance of the VSD material. In most cases, this should be minimized.

Still further, another electrical characteristic may correspond to current carrying capacity, measured as the ability of the material to sustain itself after being turned on, then off.

Table 1 and Table 2 several examples of VSD material, including VSD material composed with carbon nanotubes in accordance with one or more embodiments described herein. Table I and Table 2 each list generically measured electrical properties (meaning no differentiation is provided between forms of input signal and/or manner in which data for electrical properties is determined), as quantified by clamp and trigger voltages, that result from use of the VSD material in accordance with the stated composition.

**Table 1**

| Material | Example 1 | Example 2 | Example 3 | Example 4 | Example 5 | Example 6 |
|---|---|---|---|---|---|---|
| | Weight (g) | Weight (g) | Weight (g) | Weight (g) | Weight (g) | Weight (g) |
| Hyperion CP-1203 | 0 | 31.29 | 0 | 40.86 | 40.36 | 40.67 |
| Nickel INP400 | 216.27 | 221 49 | 0 | 0 | 71.07 | 71.02 |
| Momentive TiB2 (formerly GE) | 0 | 0 | 55.36 | 55.4 | 36.25 | 36.18 |
| Saint Gobain BN | 0 | 0 | 0 | 0 | 11.26 | 11 35 |
| Epon 828 (Hexion) | 40.13 | 10.09 | 51.06 | 12.18 | 0 | 0 |
| Degussa Dyhard T03 | 1.83 | 1.83 | 2.34 | 2.33 | 1.73 | 1.73 |
| 1-methylimidazole | 0.1 | 0.13 | 0.3 | 0.3 | 0.05 | 0.05 |
| imidazoledicarbonitrile | 0 | 0 | 0 | 0 | 6 | 0 |
| Methylaminoantracene | 0 | 0 | 0 | 0 | 0 | 6.02 |
| Millenium Chemical TiO2 | 0 | 0 | 85 03 | 85.79 | 68.62 | 68.15 |
| N-methylpyrrolidinone | 80.37 | 80.46 | 83.5 | 123.4 | 108.8 | 98.9 |
| Gap | 0.127mm (5mil) | 0.127mm (5mil) | 0.127mm (5mil) | 0.127mm (5mil) | 0.127mm (5mil) | 0.127mm (5mil) |
| Trigger Voltage | 250 | 170 | 1475 | 775 | 530 | 550 |
| Clamp Voltage | 100 | 70 | 1380 | 220 | 210 | 255 |

**Table 2**

| Material | Example 7 | Example 8 | Example 8 |
|---|---|---|---|
| | Weight (g) | Weight (g) | Weight (g) |
| Nickel INP400 | 0 | 0 | 160.28 |
| Aldrich fullerene C60 soot | 0 | 0 | 1.5 |
| Cheaptubes Carbon nanotubes | 5.4 | 5.44 | 4.0 |
| Nanophase Bi203 | 98 | 98.36 | 1.5 |
| HC Starck TiN | 164 | 164.3 | 0 |
| Epon 828 (Hexion) | 100 | 100 | 100.1 |
| Degussa Dyhard T03 | 4.56 | 4.56 | 4.65 |
| 1-methylimidazole | 0.6 | 0.6 | 0.3 |
| Saint Gobain BN | 0 | 0 | 19.67 |
| Momentive TiB2 (formerly GE) | 0 | 0 | 85.26 |
| HC Starck TiB2 | 149 | 149 | 0 |
| Millenium Chemical TiO2 | 190 | 190 | 150.59 |
| Gelest SIA610.1 | 4 | 4.05 | 0 |
| Sexithiophene | 0 | 1.03 | 0 |
| N-methylpyrrolidinone | 275.9 | 275.9 | 226.4 |
| Gap | 0.127mm (5 mil) | 0.127mm (5 mil) | 0.127mm (5 mil) |
| Trigger Voltage | 460 | 520 | 700 |
| Clamp Voltage | 348 | 413 | 380 |

With respect to Table 1, Example 1 provides a composition of VSD material that is a basis for comparison with other examples and which does not fall within the scope of the appended claims. In Example 1, no conductive or semiconductive organic material is used in the VSD material. Furthermore, the VSD material has relatively high metal loading. Example 2 illustrates a similar composition as to Example 1, but with the introduction of carbon nanotubes. The result is a reduction in trigger and clamp voltage. Trigger and clamp voltages may be reduced by adding carbon nanotubes at a given (constant) nickel loading

Example3 also illustrates a VSD composition that lacks organic conductive/semi-conductive material and is provided as a comparative example not falling within the scope of the appended claims, while Example 4 illustrates effect of including carbon nanotubes into the mixture. As shown, a dramatic reduction in the trigger and clamp voltages is shown. With regard to Example 3 and Example 4, both compositions illustrate compositions that have desirable mechanical characteristics, as well as characteristics of off-state resitivity and current-carrying mechanical characteristics, as well as characteristics of off-state resitivity and current-carrying capacity (neither of which are referenced in the chart). However, the clamp and trigger voltage values of Example 3 illustrate the composition, without inclusion of carbon nanotubes, is difficult to turn on and maintain on. Abnormally high trigger and clamp voltages thus reduce the usefulness of the composition.

Examples 5 and 6 illustrate the use of organic semiconductors with carbon nanotubes. In Example 5, the organic semiconductor is imidazoledicarbonitrile. In Example 6, the organic semiconductor is Methylaminoantracene.

Examples 7-10 shows various combinations of VSD material. Example 8 illustrates use of organic semiconductor (sexithiophene) and carbon nanotubes. Example 10 illustrates a VSD composition having multiple types of carbon nanotubes of different VSD compositions, illustrating various effects from use of conductive or semiconductive organic material, according to embodiments of the invention.

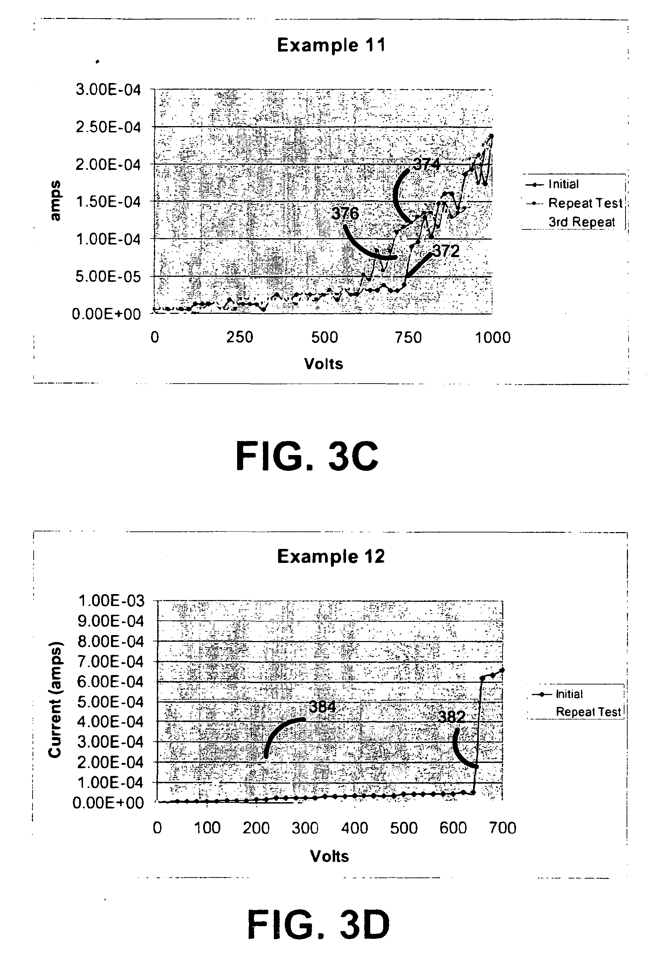

The performance diagrams shown with FIG. 3C-3E assume pulsed voltage inputs. The performance diagrams may be referenced to the examples provided in the following table.

**Table 3**

| Material | Example 11 | Example 12 | Example 13 |
|---|---|---|---|
| | Weight (g) | Weight (g) | Weight (g) |
| Hyperion CP1203 | 21.0 | 0 | 1.0 |
| Hexion Epon 828 | 50.25 | 0 | 5 |
| Cabosil coated Aluminum | 40.33 | 26.33 | 0 |
| ATA5669 aluminum | 0 | 0 | 13.76 |
| Degussa Dyhard T03 | 3.22 | 0.8 | 0.6 |
| Methoxyethanol | 25.8 | 6.39 | 4.68 |
| 1-methylimidazole | 0.06 | 0.04 | 0.04 |
| Hexion Epon SU-8 | 0 | 19.55 | 14.32 |
| Methyl ethyl ketone | 0 | 11.73 | 6.6 |
| Cabosil coated Alumina | 0 | 15.31 | 0 |

FIG. 3C is a diagram that illustrates a performance diagram for VSD material that has a relatively large quantity of concentration of carbon nanotubes in the binder of the VSD material, as described by Example 11. As shown by the diagram of FIG. 3C, the occurrence of an initial voltage event 372 in the range of 500-1000 volts results in the material turning on, so as to carry current. Application of a second voltage event 374 after the device turns off from the first event results in a similar effect as the initial event 372, in the material carries currents at relatively the same voltage levels. The occurrence of the third voltage event 376 after the device turns off the second time results in a similar result in the amperage carried in the VSD material as the first two occurrences. As such FIG. 3C illustrates the VSD material of the composition in Example 11 has relatively-high current carrying capacity, in that the VSD material remains effective after two instances of switching on and off.

FIG. 3D correlates to Example 12, which is a VSD composition that contains no conductive or semi-conductive organic material and does not fall within the scope of the appended claims. While the VSD material is effective in the first voltage event 382, there is no detectable non-linear behaviour (i.e. turn-on voltage) when the subsequent second voltage event 384 occurs.

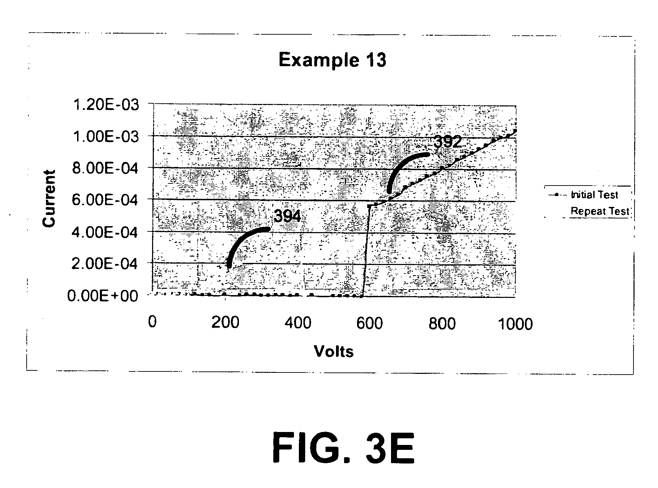

FIG. 3E correlates to Example 13, which has fewer carbon nanotubes. The light addition of such conductive/semi-conductive organic material improves the current carrying capacity of the VSD material, as shown by the amperage of the first voltage event 392 and the lesser (but present) amperage of the second voltage event 394.

COATED CONDUCTIVE OR SEMI-CONDUCTIVE PARTICLES

One or more embodiments include a formulation of VSD material that includes the use of conductive or semi-conductive micro-fillers that are coated or otherwise combined onto a periphery of a metal particle. Such formulation allows for additional reduction in the size of the metal particle and/or volume that would otherwise be occupied by the metal particle. Such reduction may improve the overall physical characteristics of the VSD material, in a manner described with other embodiments.

As described below, one or more embodiments provide for the use of conductive organic materials as micro-fillers that coat or bond metal or other inorganic conductor elements. One objective of coating the inorganic/metal particles with organic particles it to generally maintain overall volume of effective conductive material in the binder of the VSD material, while reducing a volume of metal particles in use.

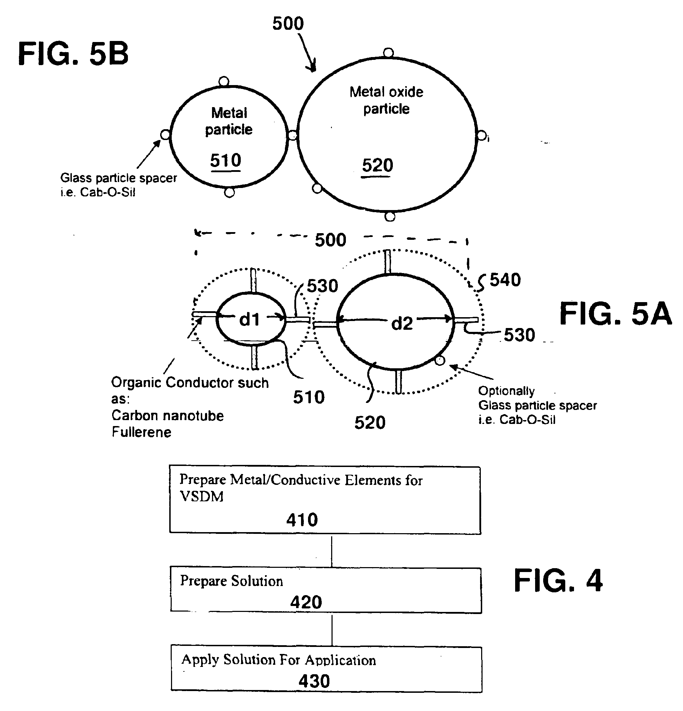

FIG. 4 illustrates a more detailed process by which VSD material can be formulated, under an embodiment of the invention. According to a step 410, the conductive elements (or semi-conductive) that are to be loaded into a binder for VSD formulation are initially prepared. This step may include combining organic material (e.g. carbon nanotubes) with particles that are to be coated so as to create a desired effect when the end mixture is cured.

In one implementation, separate preparation steps are performed for the metal and metal oxide particles. Under one embodiment, step 410 may include sub-steps of filtering aluminum and alumina powder. Each of the powder sets are then coated with an organic conductor to form the conductive/semi-conductive element. In one implementation, the following process may be used for aluminum: (i) add 1-2 millimole of silane per gram of Aluminum (dispersed in an organic solvent); (ii) apply sonic applicator to distribute particles; (iii) let react 24 hours with stirring; (iv) weigh out Cab-O-Sil or organic conductor into solution; (v) add suitable solvent to Cab-O-Sil and/or organic conductor mix; (vi) add Cab-O-Sil and/or organic conductor to collection with Aluminum; and (vii) dry overnight at 30-50 C.

Similarly, the following process may be used by used for the Alumina: (i) add 1-2 millimole of silane per gram of Alumina (dispersed in an organic solvent); (ii) apply sonic applicator to distribute particles; (iii) let react 24 hours with stirring; (iv) weigh out Cab-O-Sil or organic conductor into solution; (v) add Cab-O-Sil and/or organic conductor to collection with Alumina; (vi) dry overnight at 30-50 C.

According to an embodiment, carbon nanotubes may be used in coating or preparing the conductive elements. The carbon nanotubes may be biased to stand on end when bonded with the metal particles, so as to extend conductive length of the particles, while at the same time reducing the overall volume of metal needed. This may be accomplished by placing a chemical reactive agent on the surface perimeter of the metal particles that are to form conductors within the VSD material. In one embodiment, the metal particles may be treated with a chemical that is reactive to another chemical that is positioned at the longitudinal end of the carbon nanotube. The metal particles may be treated with, for example, a Silane coupling agent. The ends of the carbon nanotubes may be treated with the reactive agent, to enable end-wise bonding of the carbon nanotubes to the surface of the metal particles.

In step 420. a mixture is prepared. Binder material may be dissolved in an appropriate solvent. Desired viscosity may be achieved by adding more or less solvent. The conductive elements (or semi-conductive elements from step 410) are added to the binder materials. The solution may be mixed to form uniform distribution. Appropriate curative may then be added.

In step 430, the solution from step 420 is integrated or provided onto a target application (i.e. a substrate, or discrete element or a Light Emitting Diode or Organic LED), then heated or cured to form a solid VSD material. Prior to heating, the VSD material may be shaped or coated for the particular application of the VSDM. Various applications for VSD material with organic material coating metallic or inorganic conductors/semiconductors exist.

FIG. 5A and FIG. 5B illustrate how application of organic material to coat or bind the surface of the metal/inorganic conductor or semiconductors can reduce loading of such panicles, under an embodiment of the invention. FIG. 5A is a simplified illustration of how conductor and/or semiconductor particles in a binder of the VSD material can be surface coated with carbon nanotubes. As shown, conductive element 500 includes a metal particle 510 and a metal oxide or other optional inorganic semi-conductor particle 520. The metal particle 5 10 may have a dimension represented by a diameter *d1*, while the metal oxide particle 520 may have a dimension represented by d2. In an embodiment shown by FIG. 5A, conductive organic fillers 530 (e.g. carbon nanotubes) are bonded or combined with a periphery of the respective particles 510. 520. As the bonded organic fillers 530 are conductive or semi-conductive, the effect is to increase the size of the particles 510, 520 without increasing the volume of those particles in the binder of the VSD material. The presence of the organic filler enables conduction, or electron hopping or tunneling from molecule to molecule when voltage exceeding the characteristic voltage occurs. The conductive element 500 may in fact be semi-conductive, in that conductive element 500 may have the property of being collectively conductive when a characteristic voltage is exceeded.

In FIG. 5B, a conventional VSD material is shown without addition of organic material. Metal particles are relatively closely spaced in order to pass charge when voltage exceeding the characteristic voltage is applied. As a result of more closely spaced conductors, more metal loading is required to enable the device to switch to a conductor state. In comparison to an embodiment such as illustrated by FIG. 5A, under a conventional approach shown by FIG. 5B, the particles 510, 520 are spaced by glass particle spaces (e.g. Cab-O-Sil), an embodiment such as shown in FIG. 5A substitutes metal volume with conductive fillers 530 that are conductive, have desirable physical properties, and have dimensions to adequately substitute for metal.

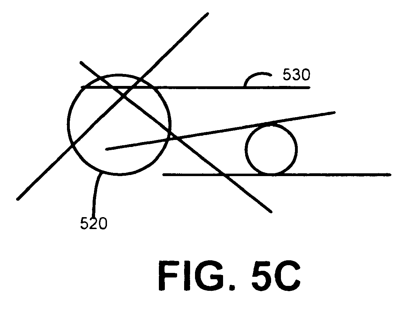

FIG. 5C illustrates a relatively disorganized distribution of organic fillers (e.g. carbon nanotubes), reflecting how the organic fillers, when uniformly dispersed at nanoscale, inherently produce results that are similar to those desired from the simplified illustration of FIG. 5A. While FIG. 5C is not to scale, a description of FIG. 5C may reflect embodiments such as shown and described with FIG. 3 or elsewhere in this application. As shown, a number of uniformly distributed conductive/semi-conductive fillers 530 enables sufficient touching and/or proximity to enable a conductive path for handling current, including through electron tunneling and hopping. This allows improvement in electrical and physical characteristics, particularly in relation to reduction of metal loading in the binder of the VSD material. Moreover, when particles are evenly dispersed at nanoscale within the binder, less organic material 530 is needed to produce the desired electrical conductivity effect.

VSD MATERIAL APPLICATIONS

Numerous applications exist for VSD material in accordance with any of the embodiments described herein. In particular, embodiments provide for VSD material to be provided on substrate devices, such as primed circuit boards, semiconductor packages, discrete devices, as well as more specific applications such as LEDs and radio-frequency devices (e.g. RFID tags). Still further, other applications may provide for use of VSD material such as described herein with a liquid crystal display, organic light emissive display, electrochromic display, electrophoretic display, or back plane driver for such devices. The purpose for including the VSD material may be to enhance handling of transient and overvoltage conditions, such as may arise with ESD events. Another application for VSDM includes metal deposition, as described in U.S. Patent No. 6,797,145 to L. Kosowsky (which is hereby incorporated by reference in its entirety).

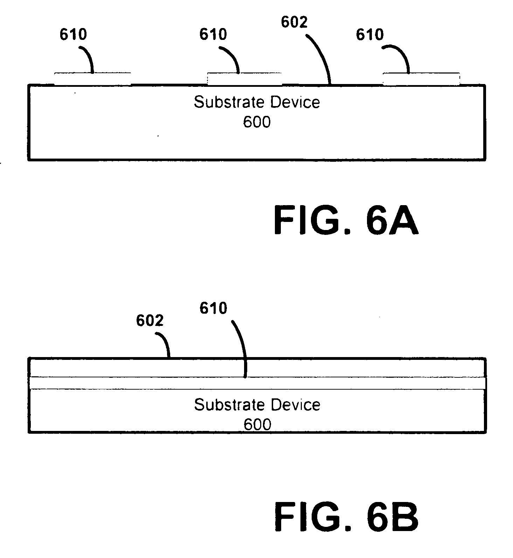

FIG. 6A and FIG. 6B each illustrate different configurations for a substrate device that is configured with VSD material having organic components ("organic VSD"), under an embodiment of the invention. In FIG. 6A, the substrate device 600 may correspond to, for example, a printed circuit board. In such a configuration, organic VSD 610 may be provided on a surface 602 to ground a connected element. As an alternative or variation, FIG. 6B illustrates a configuration in which the organic VSD forms a grounding path within a thickness 610 of the substrate.

ELECTROPLATING

In addition to inclusion of the VSD material on devices for handling, for example, ESD events one or more embodiments contemplate use of VSD material to form substrate devices, including trace elements on substrates, and interconnect elements such as vias. U.S. Patent No. 6,797,145 (incorporated herein in its entirety) recites numerous techniques for electroplating substrates, vias and other devices using VSD material. Embodiments described herein enable use of organic VSD material, as described with any of the embodiments in this application.

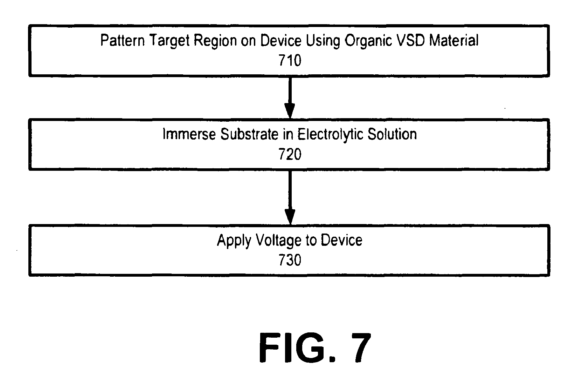

FIG. 7 illustrates a process for electroplating, using organic VSD material in accordance with any of the embodiments described with FIG. 1-5. The enhanced physical and electrical properties provided by embodiments described herein facilitate electroplating processes such as described in U.S. Patent No. 6,797,145. FIG. 7 describes a simplified electroplating process, such as described in U.S. Patent No. 6.797,145., in which the VSD material used is in accordance with any of the embodiments described with FIG. 1 thru FIG. 5.

In FIG. 7, a basic electroplating technique is described, according to one or more embodiments of the intention. In a step 710, a target region of a device (e.g. a substrate) is patterned using organic VSD material. The patterning may be performed by, for example, applying a continuous layer of VSD over a substrate, then placing a mask over the VSD layer. The mask may define the negative pattern of the desired electrical/trace pattern. Alternatives are also possible. For example, the VSD material may be applied to the entire region, and then selectively removed to expose regions that are intended to not have current-carrying elements. Still further, the VSD material may be pre-patterned on the target region.

Step 720 provides that the substrate is immersed in an electrolytic solution.

Step 730 provides that a voltage in excess of the characteristic voltage is applied to the patterned region of the device. The application of the voltage may be pulsed to occur for a designated duration of time that is less than the break-down time. The break-down time may correspond to the minimum duration in which the organic VSD material is known to break-down when the given voltage is applied. At break-down, the organic VSD material may lose its electrical characteristics, including its switching characteristics. The pattern of current carrying traces and elements may substantially match that of the organic VSD material. In the electrolytic solution, charged elements attract and bond to the exposed regions of the organic VSD material, forming current carrying traces and elements on the device.

In particular, one or more embodiments for electroplating onto devices includes using VSD material that has reduced metallic loading through use of organic material, such as carbon nanotubes. Such formulation enables longer pulse time for performing the plating steps of 720 and 730, as compared to conventional VSD materials. Moreover, use of organic VSD material increases a likelihood that the VSD material will retain its integrity after the plating process. This means that the trace elements may be provided with inherent grounding capabilities that can be integrated into the device.

Consistent with an embodiment of FIG. 7, use of VSD material in accordance with embodiments described herein may be applied to any of the electroplating techniques described in U.S. Patent No. 6,797,145. Electroplating techniques with organic VSD material as described may be used to (i) create vias on a substrate device, (ii) multi-sided substrate devices having current carrying patterns on each side, and/or (iii) interconnecting vias between multi-sided substrate devices, having current carrying patterns on each side.

OTHER APPLICATIONS

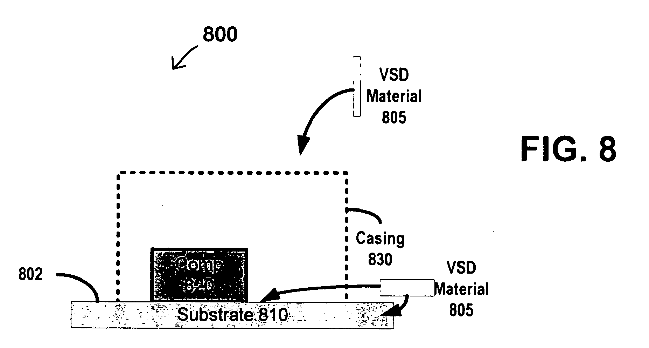

FIG. 8 is a simplified diagram of an electronic device on which VSD material in accordance with embodiments described herein may be provided. FIG. 8 illustrates a device 800 including substrate R10. component 820, and optionally casing or housing 830. VSD material 805 may be incorporated into any one or more of many locations, including at a location on a surface 802, underneath the surface 802 (such as under its trace elements or under component 820), or within a thickness of substrate 810. Alternatively, the VSD material may be incorporated into the casing 830. In each case, the VSD material 805 may be incorporated so as to couple with conductive elements, such as trace leads, when voltage exceeding the characteristic voltage is present. Thus, the VSD material 805 is a conductive element in the presence of a specific voltage condition.

With respect to any of the applications described herein, device 800 may be a display device. For example, component 820 may correspond to an LED that illuminates from the substrate 810. The positioning and configuration of the VSD material 805 on substrate 810 may be selective to accommodate the electrical leads, terminals (i.e. input or outputs) and other conductive elements that are provided with, used by or incorporated into the light-emitting device. As an alternative, the VSD material may be incorporated between the positive and negative leads of the LED device, apart from a substrate. Still further, one or more embodiments provide for use of organic LEDs, in which case VSD material may be provided, for example, underneath the OLED.

With regard to LEDs, any of the embodiments described in U.S. Patent Application No. 11.562.289 (which is incorporated by reference herein) may be implememed with VSD material containing a binder with conductive semi-conductive organic material, in accordance with any of the embodiments described herein.

Alternatively, the device 800 may correspond to a wireless communication device, such as a radio-frequency identification device. With regard to wireless communication devices such as radio-frequency identification devices (RFID) and wireless communication components, VSD material may protect a component 820 from, for example, overcharge or ESD events. In such cases, component 820 may correspond to a chip or wireless communication component of the device. Alternatively, the use of VSD material 805 may protect other components from charge that may be caused by the component 820. For example, component 820 may correspond to a battery, and the VSD material 805 may be provided as a trace element on a surface of the substrate 810 to protect against voltage conditions that arise from a battery event.

Any of the embodiments described in U.S. Patent Application No. 11/562,222 (which is incorporated by reference herein) may be implemented with VSD material containing a binder with conductive/semi-conductive organic material, in accordance with any of the embodiments described herein.

As an alternative or variation, the component 820 may correspond to, for example, a discrete semiconductor device. The VSD material 805 may be integrated with the component, or positioned to electrically couple to the component in the presence of a voltage that switches the material on.

Still further, device 800 may correspond to a packaged device, or alternatively, a semiconductor package for receiving a substrate component VSD material 805 may be combined with the casing 830 prior to substrate 810 or component 820 being included in the device.

CONCLUSION

Embodiments described with reference to the drawings are considered illustrative, and Applicant's claims should not be limited to details of such illustrative embodiments. Various modifications and variations will may be included with embodiments described, including the combination of features described separately with different illustrative embodiments. Accordingly, it is intended that the scope of the invention be defined by the following claims. Furthermore, it is contemplated that a particular feature described either individually or as part of an embodiment can be combined with other individually described features, or parts of other embodiments, even if the other features and embodiments make no mentioned of the particular feature.

## Claims

1. A composition comprising:
a binder;
organic material that is conductive or semi-conductive, wherein said organic material is either solvent soluble or dispersed within the binder at nanoscale; and
conductor and/or semiconductor particles other than said organic material distributed uniformly within the binder;
wherein said organic material and said conductor and/or semiconductor particles are combined to provide said composition with a characteristic of being (i) dielectric in absence of a voltage that exceeds a characteristic voltage level, and (ii) conductive with application of said voltage exceeding said characteristic voltage level;
wherein the organic material includes single and/or multi-walled carbon nanotubes.

2. The composition of claim 1, wherein the organic material includes a conductive or semi-conductive monomer, oligomer, or polymer.

3. The composition of claim 1, wherein the organic material includes electron donor and/or electron acceptor molecules or polymers.

4. The composition of claim 1, wherein the organic material includes a compound selected from a class ofthiophenes, aniline, phenylenes, vinylenes, naphthalene, pyrrole, acetylene, carbazole, pyrrolidone, cyano materials, anthracene, pentacene, rubrene, or perylene.

5. The composition of claim 1, wherein the organic material includes a compound selected from Poly(3,4ethylenedioxythiophene)/poly(styrenesulfonate), (8-hydroxyquinolinolato) aluminum (III), N,N'-Bis(3-methylphenyl-N,N'-diphenylbenzidine [TPD], N,N'-Di-[(naphthalenyl)-NN'diphenyl]-1,1'-biphenyl-4,4'-diamine [NPD].

6. The composition of claim 1, wherein said organic material includes a pure carbon compound corresponding to one of carbon graphite, carbon fiber, or a diamond powder.

7. The composition of claim 1, wherein the conductor and/or semiconductor particles includes a metal or a metal complex.

8. The composition of claim 7, wherein the metal complex is selected from a group consisting of oxides, metal nitrides, metal carbides, metal borides, metal sulfides, or a combination thereof

9. The composition of claim 1, wherein the conductor and/or semiconductor particles include a titanium compound.

10. The composition of claim 9, wherein the conductor and/or semiconductor particles include titanium dioxide.

11. The composition of claim 9, wherein the titanium compound includes titanium diboride or titanium nitride.

12. The composition of claim 1, further comprising inorganic semi-conductor particles distributed in the binder.

13. The composition of claim 12, wherein the inorganic semi-conductor particles include particles selected from a group consisting of silicon, silicon carbide, boron nitride, aluminum nitride, nickel oxide, zinc oxide, zinc sulfide, bismuth oxide, cerium oxide, iron oxide.

14. The composition of claim 1, where at least some of the conductor and/or semiconductor particles are surface bonded by said organic material.

15. The composition of claim 14, wherein said organic material that surface coats the conductor and/or semiconductor particles includes carbon nanotubes.

16. The composition of claim 15, wherein the conductor and/or semiconductor particles includes one of titanium dioxide, titanium nitride, titanium diboride.

17. The composition of claim 14, wherein said organic material that surface coats the conductor and/or semiconductor particles includes organic conductive particles that are grafted onto a surface of individual conductive particles in the binder.

18. The composition of claim 1, wherein the binder material is formed from a material selected from a group consisting of silicone polymers, epoxy, polyimide, polyethylene, phenolic resin, polypropylene, polyphenylene oxide, polysulphone, solgel mateterials, ceramers.

19. The composition of claim 1, wherein said organic material includes a chemical moiety that covalently bonds to the binder.

20. An electronic device comprising a composition as claimed in any of claims 1-19.

21. The electronic device of claim 20, wherein the device is a device selected from a group consisting of a discrete device, a semi-conductor package, a display device or backplane, a light-emitting diode, and a radio-frequency identification device.

## Patentansprüche

1. Zusammensetzung, umfassend:
ein Bindemittel;
organisches Material, das leitend oder halbleitend ist, wobei das organische Material entweder lösungsmittellöslich oder innerhalb des Bindemittels im Nanobereich dispergiert ist; und
andere Leiter- und/oder Halbleiterteilchen als das organische Material, die gleichmäßig innerhalb des Bindemittels verteilt sind;
wobei das organische Material und die Leiter- und/oder Halbleiterteilchen so kombiniert sind, dass sie der Zusammensetzung die Eigenschaft verleihen, (i) bei Fehlen einer Spannung, die einen charakteristischen Spannungspegel überschreitet, dielektrisch zu sein und (ii) bei Anlegen der Spannung, die den charakteristischen Spannungspegel überschreitet, leitend zu sein;
wobei das organische Material ein- und/oder mehrwandige Kohlenstoff-Nanoröhrchen umfasst.

2. Zusammensetzung nach Anspruch 1, wobei das organische Material ein leitendes oder halbleitendes Monomer, Oligomer oder Polymer umfasst.

3. Zusammensetzung nach Anspruch 1, wobei das organische Material Elektronenspender- und/oder Elektronenempfänger-Moleküle oder -Polymere umfasst.

4. Zusammensetzung nach Anspruch 1, wobei das organische Material eine Verbindung umfasst, die aus einer Klasse von Thiophenen, Anilin, Phenylenen, Vinylenen, Naphthalen, Pyrrol, Acetylen, Carbazol, Pyrrolidon, Cyano-Materialen, Anthracen, Pentacen, Rubren oder Perylen ausgewählt ist.

5. Zusammensetzung nach Anspruch 1, wobei das organische Material eine Verbindung umfasst, die aus Poly(3,4-ethylendioxythiophen)/Poly(styrolsulfonat), (8-Hydroxychinolinolato)-Aluminium(III), N,N'-Bis(3-methylphenyl-N,N'-diphenylbenzidin [TPD], N,N'-Di-[(naphthalenyl)-N,N'-diphenyl]-1,1'-biphenyl-4,4'-diamin [NPD] ausgewählt ist.

6. Zusammensetzung nach Anspruch 1, wobei das organische Material eine reine Kohlenstoffverbindung umfasst, die einem von Kohlenstoffgraphit, Kohlenstofffaser oder einem Diamantpulver entspricht.

7. Zusammensetzung nach Anspruch 1, wobei die Leiter-und/oder Halbleiterteilchen ein Metall oder einen Metallkomplex umfassen.

8. Zusammensetzung nach Anspruch 7, wobei der Metallkomplex aus einer Gruppe bestehend aus Oxiden, Metallnitriden, Metallcarbiden, Metallboriden, Metallsulfiden oder einer Kombination davon ausgewählt ist.

9. Zusammensetzung nach Anspruch 1, wobei die Leiter-und/oder Halbleiterteilchen eine Titanverbindung umfassen.

10. Zusammensetzung nach Anspruch 9, wobei die Leiter-und/oder Halbleiterteilchen Titandioxid umfassen.

11. Zusammensetzung nach Anspruch 9, wobei die Titanverbindung Titandiborid oder Titannitrid umfasst.

12. Zusammensetzung nach Anspruch 1, ferner umfassend anorganische Halbleiterteilchen, die im Bindemittel verteilt sind.

13. Zusammensetzung nach Anspruch 12, wobei die anorganischen Halbleiterteilchen Teilchen umfassen, die aus einer Gruppe bestehend aus Silicium, Siliciumcarbid, Bornitrid, Aluminiumnitrid, Nickeloxid, Zinkoxid, Zinksulfid, Bismutoxid, Ceroxid, Eisenoxid ausgewählt sind.

14. Zusammensetzung nach Anspruch 1, wobei wenigstens einige der Leiter- und/oder Halbleiterteilchen durch das organische Material oberflächengebunden sind.

15. Zusammensetzung nach Anspruch 14, wobei das organische Material, das die Leiter- und/oder Halbleiterteilchen oberflächenbeschichtet, Kohlenstoff-Nanoröhrchen umfasst.

16. 2zusammensetzung nach Anspruch 15, wobei die Leiter-und/oder Halbleiterteilchen eines von Titandioxid, Titannitrid, Titandiborid umfassen.

17. Zusammensetzung nach Anspruch 14, wobei das organische Material, das die Leiter- und/oder Halbleiterteilchen oberflächenbeschichtet, organische leitende Teilchen umfasst, die auf eine Oberfläche von einzelnen leitenden Teilchen im Bindemittel aufgepfropft sind.

18. Zusammensetzung nach Anspruch 1, wobei das Bindemittelmaterial aus einem Material gebildet ist, das aus einer Gruppe bestehend aus Silikonpolymeren, Epoxidharz, Polyimid, Polyethylen, Phenolharz, Polypropylen, Polyphenylenoxid, Polysulfon, Sol-Gel-Materialien, Cerameren ausgewählt ist.

19. Zusammensetzung nach Anspruch 1, wobei das organische Material eine chemische Komponente umfasst, die kovalent an das Bindemittel bindet.

20. Elektronisches Bauelement, umfassend eine Zusammensetzung nach einem der Ansprüche 1 bis 19.

21. Elektronisches Bauelement nach Anspruch 20, wobei das Bauelement ein Bauelement ist, das aus einer Gruppe bestehend aus einem diskreten Bauelement, einer Halbleiterpackung, einem Anzeige-Bauelement oder einer Anzeige-Rückwandplatine, einer Leuchtdiode und einem Radiofrequenz-Identifizierungsbauelement ausgewählt ist.

## Revendications

1. Composition comprenant :
un liant ;
un matériau organique qui est conducteur ou semi-conducteur, ledit matériau organique étant soluble dans un solvant ou dispersé dans le liant à l'échelle nanoscopique ; et
des particules conductrices et/ou semi-conductrices différentes dudit matériau organique distribuées uniformément dans le liant ;
ledit matériau organique et lesdites particules conductrices et/ou semi-conductrices se combinant pour conférer à ladite composition la caractéristique d'être (1) diélectrique en l'absence d'une tension supérieure à une valeur de tension caractéristique, et (ii) conductrice si ladite tension supérieure à la valeur de tension caractéristique est appliquée ;
dans laquelle ledit matériau organique comprend des nanotubes de carbone à paroi unique et/ou multiparois.

2. Composition de la revendication 1, dans laquelle le matériau organique comprend un monomère, un oligomère ou un polymère conducteur ou semi-conducteur.

3. Composition de la revendication 1, dans laquelle le matériau organique comprend des molécules ou des polymères donneurs d'électrons et/ou accepteurs d'électrons.

4. Composition de la revendication 1, dans laquelle le matériau organique comprend un composé choisi dans l'ensemble comprenant les thiophènes, l'aniline, les phénylènes, les vinylènes, le naphtalène, le pyrrole, l'acétylène, le carbazole, la pyrrolidone, les matériaux à groupement cyano, l'anthracène, le pentacène, le rubrène ou le pérylène.

5. Composition de la revendication 1, dans laquelle le matériau organique comprend un composé choisi parmi le poly(3,4-éthylènedioxythiophène)/poly(styrène sulfonate), le (8-hydroxyquinolinolato)aluminium (III), le N,N'-bis(3-méthylphényl-N,N'-diphénylbenzine [TPD], le N,N'-di[(naphtalényl)-N,N'diphényl]-1,1'-biphényl-4,4'-diamine [NPD].

6. Composition de la revendication 1, dans laquelle le matériau organique comprend un composé de carbone pur correspondant à un composé parmi le carbone graphite, une fibre de carbone, ou une poudre de diamant.

7. Composition de la revendication 1, dans laquelle les particules conductrices et/ou semi-conductrices comprennent un métal ou un complexe métallique.

8. Composition de la revendication 7, dans laquelle le complexe métallique est choisi dans l'ensemble constitué d'oxydes, de nitrures de métaux, de carbures de métaux, de borures de métaux, de sulfures de métaux ou d'une de leurs combinaisons.

9. Composition de la revendication 1, dans laquelle les particules conductrices et/ou semi-conductrices comprennent un composé de titane.

10. Composition de la revendication 9, dans laquelle les particules conductrices et/ou semi-conductrices comprennent du dioxyde de titane.

11. Composition de la revendication 9, dans laquelle le composé de titane comprend du diborure de titane ou du nitrure de titane.

12. Composition de la revendication 1, comprenant en outre des particules semi-conductrices inorganiques distribuées dans le liant.

13. Composition de la revendication 12, dans laquelle les particules semi-conductrices inorganiques comprennent des particules choisies dans l'ensemble constitué de silicium, carbure de silicium, nitrure de bore, nitrure d'aluminium, oxyde de nickel, oxyde de zinc, sulfure de zinc, oxyde de bismuth, oxyde de cérium, oxyde de fer.

14. Composition de la revendication 1, dans laquelle certaines des particules conductrices et/ou semi-conductrices sont liées en surface par ledit matériau organique.

15. Composition de la revendication 14, dans laquelle ledit matériau organique qui recouvre la surface desdites particules conductrices et/ou semi-conductrices comprend des nanotubes de carbone.

16. Composition de la revendication 15, dans laquelle les particules conductrices et/ou semi-conductrices comprennent un composé parmi le dioxyde de titane, le nitrure de titane ou le diborure de titane.

17. Composition de la revendication 14, dans laquelle ledit matériau organique qui recouvre la surface des particules conductrices ou semi-conductrices comprend des particules organiques conductrices qui sont greffées sur une surface des particules conductrices individuelles dans le liant.

18. Composition de la revendication 1, dans laquelle le matériau liant est formé d'un matériau choisi dans un ensemble constitué de polymères de silicone, époxy, polyimide, polyéthylène, résine phénolique, polypropylène, poly(phénylène oxyde), polysulfone, matériaux sol-gel, céramères.

19. Composition de la revendication 1, dans laquelle ledit matériau organique comprend un fragment chimique qui se lie par covalence au liant.

20. Dispositif électronique comprenant une composition revendiquée dans l'une quelconque des revendications 1-19.

21. Dispositif électronique de la revendication 20, le dispositif étant un dispositif choisi dans un ensemble constitué d'un composant discret, d'un boîtier semi-conducteur, d'un dispositif d'affichage ou d'un fond de panier, d'une diode électroluminescente et d'un dispositif d'identification de radiofréquences.
